# EUROPÄISCHE PATENTSCHRIFT

(11) **EP 0 894 751 B1**
(45) Veröffentlichungstag und Bekanntmachung des Hinweises auf die Patenterteilung: **21.11.2001**
(21) Anmeldenummer: 97112966.3
(22) Anmeldetag: 28.07.1997
(51) Int. Cl.: B65G 47/50, H01L 21/00, H05K 13/00

(54) **Transportsystem und Verfahren zur Steuerung des Transportsystems**
Transport system and controlling procedure for that system
Système de transport et procédé de contrôle de ce système

(43) Veröffentlichungstag der Anmeldung: 03.02.1999
(73) Patentinhaber: Infineon Technologies AG, 81669 München (DE)
(72) Erfinder: Welzk, André Dipl.-Ing., D-01273 Dresden (DE); Heinrich, Harald Dipl.-Ing., D-14478 Potsdam (DE); Odrich, Falk Dipl.-Ing., D-01809 Röhrsdorf (DE); Oesterreich, Peter Cand.-Ing., D-01640 Coswig (DE); Recklies, Jörg Dipl.-Ing., D-09397 Neuwürschnitz (DE)
(74) Vertreter: Zedlitz, Peter, Dipl.-Inf.

(56) Entgegenhaltungen:
- EP-A- 0 003 024
- DE-A- 3 010 637
- US-A- 3 576 540
- US-A- 4 719 694
- US-A- 4 805 759
- US-A- 4 917 556

## Beschreibung

Die vorliegende Erfindung betrifft ein Transportsystem bzw. ein Verfahren zur Steuerung eines Transportsystems. Solche Transportsysteme werden im Ausführungsbeispiel bei der Fertigung von Wafern eingesetzt und sind ein wesentlicher Bestandteil des Produktions- und Automatisierungskonzeptes.

Herkömmliche Transportsysteme, die zum Beispiel als Wagensysteme bekannt sind, weisen zahlreiche Nachteile auf, wobei wesentliche Nachteile dieser bekannten Systeme darin zu sehen sind, daß eine Erweiterung oder Änderung der Transportwege nur mit großem Aufwand durchführbar ist, und daß die Steuerung fehleranfällig arbeitet. Diese Nachteile sind u.a. darauf zurück zu führen, daß eine übergeordnete Steuerungseinheit für alle anfallenden Daten zuständig ist und daß im Transportsystem zu wenige Kontrollpunkte vorgesehen sind, die eine Überwachung der einzelnen Wagen ermöglichen könnten. Im Fehlerfall tritt eine Fehlerfortpflanzung auf, die aufgrund der wenigen Kontrollpunkte und aufgrund der umfangreichen Systemkommunikation, die eine übergeordnete Steuerungseinheit zu verarbeiten hat, zum Ausfall des vollständigen Transportsystems führen kann.

US-A-3 576 540 zeigt ein gattungsgemäßes Transportsystem.

Demgegenüber ist es die Aufgabe der vorliegenden Erfindung, ein Transportsystem und ein Verfahren zur Steuerung eines Transportsystems zu schaffen, bei dem die Robustheit des Systems gewährleistet ist und auch im Fehlerfall oder bei Ausfall einzelner Komponenten das Restsystem stabil weiter arbeitet.

Diese Aufgabe wird durch ein Transportsystem gemäß dem Patentanspruch 1 bzw. durch ein Verfahren zur Steuerung eines Transportsystems gemäß dem Patentanspruch 16 gelöst.

Demnach umfaßt ein Transportsystem, das insbesondere zum Transport von Wafern eingesetzt wird, eine Vielzahl von Trägereinrichtungen, die die Wafer aufnehmen, eine Vielzahl von Fördereinrichtungen, die die Trägereinrichtungen transportieren, eine Vielzahl von Verzweigungseinrichtungen, die die Trägereinrichtungen zu unterschiedlichen Fördereinrichtungen verzweigen, eine Vielzahl von Ein- bzw. Ausgängen (Liften) an Bearbeitungseinrichtungen, an denen die Wafer bearbeitet werden, und eine Vielzahl von Lagereinrichtungen, in denen die Trägereinrichtungen mit den Wafern zwischengelagert werden, wobei jede Trägereinrichtung einen Informationsträger aufweist, in dem zumindest eine erste Zieladresse gespeichert ist, so daß die zugehörigen Wafer zu einer bestimmten, dieser Zieladresse entsprechenden Bearbeitungseinrichtung transportierbar sind, diese erste Zieladresse an jedem Lift an einer Bearbeitungseinrichtung gelesen wird und nach der Bearbeitung vom Lift eine zweite Zieladresse geschrieben wird, und jede Verzweigungseinrichtung mittels einer internen Zieladressenliste die Verzweigungsrichtung festlegt, indem an jeder Verzweigungseinrichtung der Informationsträger jeder Trägereinrichtung ausgelesen wird.

Merkmale vorteilhafter Weiterbildungen des Transportsystems sind in den Unteransprüchen 2 bis 15 angeführt.

Gemäß Patentanspruch 2 entspricht die zweite Zieladresse einem Fertigungsbereich, wobei das Transportgut nach der Bearbeitung an der ersten Zieladresse zu einer ersten Lagereinrichtung dieses Fertigungsbereiches transportiert wird.

In Übereinstimmung mit dem Patentanspruch 3 steuert, wenn die erste Lagereinrichtung dieses Fertigungsbereiches belegt ist, das Transportgut sukzessive alle anderen Lagereinrichtungen dieses Fertigungsbereiches an, bis ein freier Lagerplatz erreicht ist.

Die Weiterbildungen nach Anspruch 2, 3 und 4 dienen der unabhängigen Steuerung, so daß auf einer untersten Steuerungsebene des Transportsystems die Transportverfolgung ausgeführt ist.

Gemäß Patentanspruch 4 wird das Transportgut in diesem Fertigungsbereich im Kreis transportiert, falls alle Lagereinrichtungen belegt sind, so daß die Fördereinrichtungen selbst als Zwischenlager für die Transportgüter eingesetzt sind.

Nach einer Weiterbildung gemäß Patentanspruch 5 sind die Zieladressenlisten in jeder Verzweigungseinrichtung spezifisch aufgebaut und umfassen sämtliche über diese Verzweigungseinrichtung erreichbare Ziele, wobei nach Patentanspruch 6 die Zieladressenlisten nur die Ziele umfassen, die nicht in einer Vorzugsrichtung der Verzweigungseinrichtung zu erreichen sind. Hierdurch wird eine Optimierung der Adressenlisten erreicht, so daß einerseits deren Umfang gering gehalten ist und andererseits trotzdem Alternativrouten befahrbar sind.

Eine weitere Verbesserung der Routenplanung ergibt sich durch die Lehre des Patentanspruches 7, wonach jede Verzweigungseinrichtung zusätzlich die Aktivitäten benachbarter Verzweigungseinrichtungen berücksichtigt, wenn die Verzweigungsrichtung bestimmt wird, um die Transportstrecke zu optimieren. Hierdurch können bereits stark belastete Transportstrecken umgangen werden.

Gemäß Patentanspruch 8 ist der Inhalt des Informationsträgers am Transportgut nicht flüchtig, so daß auch nach einem Stromausfall die Zieladressen erhalten sind und der Transportauftrag fortgesetzt werden kann.

Um auf Ausnahmesituationen geeignet reagieren zu können, umfaßt nach Patentanspruch 11 das Transportsystem in jeder Verzweigungseinrichtung zusätzliche Adressenlisten, die in Ausnahmesituationen, wie Feueralarm, Abschaltung des Transportsystems und Teilabschaltungen des Transportsystems aktivierbar sind, wobei nach Patentanspruch 12 die Zieladressenlisten und die zusätzlichen Adressenlisten kontinuierlich aktualisiert werden, um Veränderungen im Aufbau des Transportsystems laufend zu erfassen.

Um die Transportsicherheit weiter zu erhöhen, sind in Übereinstimmung mit den Patentansprüchen 13 bis 15 Maßnahmen vorgesehen, die eine Feststellung von Transportaufträgen sicherstellen, die außergewöhnlich lange unterwegs sind, wobei ein Transportauftrag durch Auslagerung des Transportgutes aus der Lagereinrichtung aufgenommen wird, der Informationsträger dieses Transportgutes mit den Zieladressen beschrieben wird, dieses Transportgut mittels der Fördereinrichtungen transportiert wird und mittels der Verzweigungseinrichtungen in Richtung zur ersten Zieladresse verzweigt wird, wobei nach Erreichen der ersten Zieladresse entsprechenden Bearbeitungseinrichtung die Bearbeitung durchgeführt wird und danach das Transportgut mit der zweiten Zieladresse versehen wird, um weiter transportiert zu werden, wobei, falls die Zeitspanne zwischen Auslagerung und Bearbeitung größer als eine vorbestimmte Zeitdauer ist, das Transportgut auf eine Fehlerliste gesetzt wird.

Zur eindeutigen Identifizierung des Transportgutes ist jedem Transportgut eine spezifische Nummer zugewiesen, die ebenfalls im Informationsträger abgespeichert ist, wobei diese Nummer in die oben erwähnte Fehlerliste eingetragen wird.

Das erfindungsgemäße Verfahren zeichnet sich nach Patentanspruch 16 durch die folgenden Schritte aus: Auslagern eines Transportgutes aus einer Lagereinrichtung, Einspeichern von zumindest einer ersten Zieladresse in einen Informationsträger des Transportgutes, Transportieren des Transportgutes mittels einer Vielzahl von Fördereinrichtungen, wobei eine Vielzahl von Verzweigungseinrichtungen zwischen den Fördereinrichtungen vorgesehen ist, um das Transportgut zu unterschiedlichen Fördereinrichtungen zu verzweigen, Auslesen der Zieladresse aus dem Informationsträger des Transportgutes an jeder Verzweigungseinrichtung, Vergleichen der gelesenen Zieladresse mit einer internen Zieladressenliste in der Verzweigungseinrichtung, Einstellen der Verzweigungsrichtung der Verzweigungseinrichtung in Abhängigkeit von dem Ergebnis dieses Vergleiches, so daß das Transportgut in Richtung der ersten Zieladresse verzweigt wird, Wiederholen der Schritte Transportieren/Auslesen/Vergleichen/Einstellen, bis eine der Zieladresse entsprechende Bearbeitungseinrichtung erreicht ist, Bearbeiten des Produktes, Einspeichern und/oder Lesen einer zweiten Zieladresse in den bzw. aus dem Informationsträger, um das Transportgut zu einem nächsten Fertigungsbereich weiter zu transportieren.

Merkmale vorteilhafter Weiterbildungen des Verfahrens zur Steuerung des Transportsystems sind in den Unteransprüchen 17 bis 21 angeführt.

Gemäß Anspruch 17 umfassen die jeweiligen internen Zieladressenlisten sämtliche über die Verzweigungseinrichtungen erreichbare Ziele, so daß eine Optimierung der Transportstrecken und eine alternative Streckenführung der Transportgüter durchführbar ist.

Um die Kommunikation im System zu minimieren, kann in Übereinstimmung mit dem Anspruch 18 eine zweite Zieladresse zusammen mit der ersten Zieladresse in den Informationsträger bei der Auslagerung geschrieben werden und nach der Bearbeitung wird dann die erste Zieladresse durch die zweite Zieladresse ersetzt bzw. überschrieben.

Gemäß dem Grundgedanken der vorliegenden Erfindung, nämlich eine dezentrale Transportverfolgung auf einer untersten Steuerungsebene zu realisieren, ermittelt die Verzweigungseinrichtung mittels der internen Zieladressenliste die Verzweigungsrichtung unabhängig von einer übergeordneten Steuerungseinrichtung, wobei nach Anspruch 20 diese übergeordnete Steuerungseinrichtung eine Aktualisierung der Zieladressenliste in den Verzweigungseinrichtungen dann durchführt, wenn sich die Konfiguration (Erweiterung, Veränderung, (Teil-) Abschaltung von Transportstrecken, zusätzliche Verzweigungseinrichtungen, etc.) des Transportsystems verändert.

Gemäß Anspruch 21 sind zusätzlich zu den internen Zieladressenlisten in den Verzweigungseinrichtungen weitere Adressenlisten abgelegt, die in Ausnahmefällen, wie beispielsweise Feueralarm oder (Teil-) Abschaltung des Transportsystems aktivierbar sind.

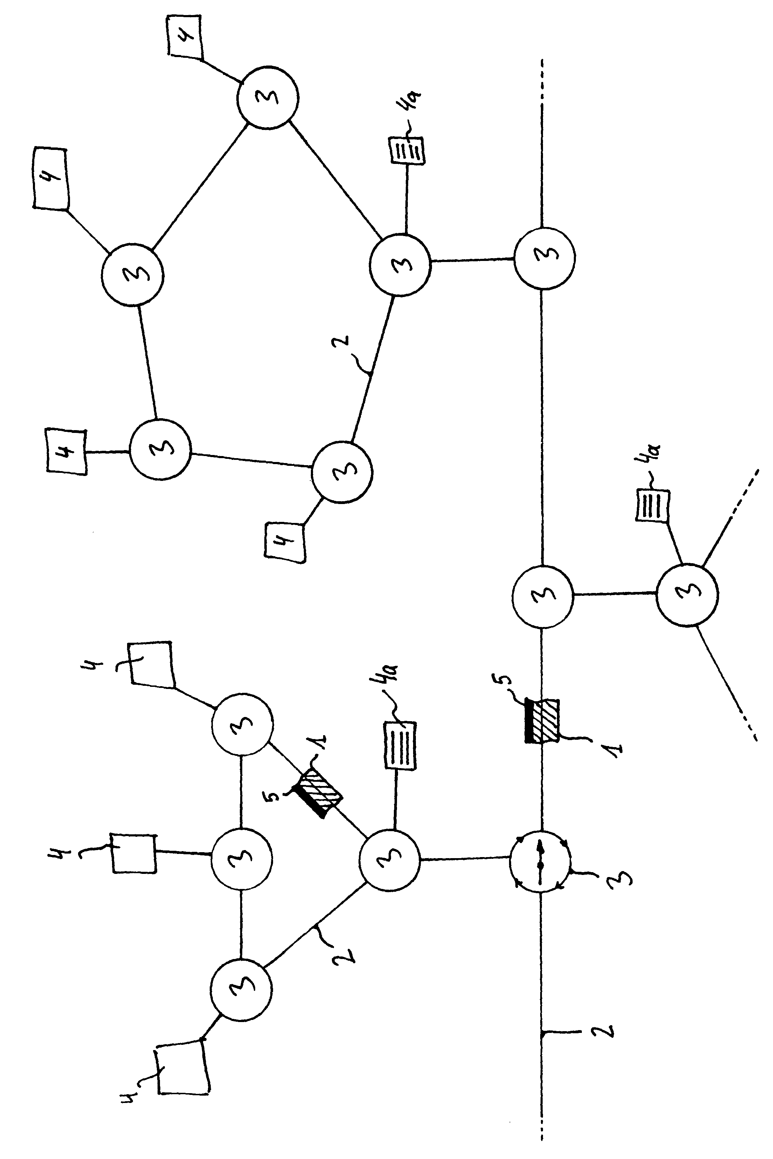

Weitere Merkmale und Vorteile ergeben sich aus der folgenden Beschreibung.
Die Erfindung wird nun anhand der zugehörigen Zeichnung näher beschrieben. In der Figur ist schematisch ein Transportsystem ausschnittsweise dargestellt.

In der Figur sind einzelne Komponenten eines Transportsystems symbolisch wiedergegeben. So ist mit dem Bezugszeichen 1 ein Transportgut (im Beispiel ein Carrier für einen oder mehrere Wafer) bezeichnet. Dieses Transportgut 1 wird mittels einer Mehrzahl von Fördereinrichtungen 2 (im Beispiel Conveyer) transportiert und somit kann das Transportgut zu beliebigen Bearbeitungseinrichtungen 4 (im Beispiel bis zum Lift an der Bearbeitungseinrichtung) oder Lagereinrichtungen 4a (im Beispiel Stocker) transportiert werden. Zwischen den unterschiedlichen Fördereinrichtungen 2 befinden sich Verzweigungseinrichtungen 3 (z.B. Drehteller), die die Transportgüter 1 in unterschiedliche Richtungen verzweigen. An jedem Transportgut 1 ist ein Informationsträger 5 (im Beispiel ein sogenannter Tag) vorgesehen, der zumindest die Adresse der nächsten anzulaufenden Bearbeitungseinrichtung 4 gespeichert hat. Da an jeder Verzweigungseinrichtung 3 eine Leseeinrichtung vorgesehen ist, um diesen Informationsträger 5 des Transportgutes 1 auszulesen, kann durch einen Vergleich zwischen einer in jeder der Verzweigungseinrichtungen 3 intern gespeicherten Zieladressenliste und der ausgelesenen Adresse die Verzweigungsrichtung bestimmt werden. Dementsprechend wird die Verzweigungseinrichtung 3 gedreht und das Transportgut 1 in Richtung der anzulaufenden Bearbeitungseinrichtung 4 gefördert.

Die folgenden Begriffe werden zum besseren Verständnis kurz erläutert:

Transportgut: Trägereinrichtung mit oder ohne dem zu transportierenden Produkt oder das Produkt selbst, wenn keine Trägereinrichtung vorhanden ist (Bei dem im Text genannten Ausführungsbeispiel besteht das Transportgut aus einer Trägereinrichtung, die das zu bearbeitende Produkt, die Wafer aufnimmt).

Ein- bzw. Ausgang des Transportsystems: Punkte an denen das Transportgut das Transportsystem verläßt bzw. in das System eintritt (zum Beispiel Übergänge zu den Bearbeitungsstationen - im Ausführungsbeispiel sind es Lifte).

Zur Koordination der Steuerung ist eine übergeordnete Steuerungseinrichtung (nicht dargestellt) vorgesehen. Diese Steuerungseinrichtung (Controlsystem) übermittelt über eine Netzwerkverbindung an die Lagereinrichtung 4a die Information, die erforderlich ist, um zu bestimmen, welches Transportgut 1 aus der Lagereinrichtung 4a auszulagern ist und zu welchem Ziel, d.h. zu welcher Bearbeitungseinrichtung 4 dieses Transportgut 1 zu schicken bzw. zu fördern ist. Vorzugsweise kann darüber hinaus eine weitere Information übertragen werden, nämlich wohin dieses Transportgut 1 nach der Bearbeitungseinrichtung 4 zu transportieren ist.

Hierzu ist in der Lagereinrichtung 4a eine Schreibeinrichtung (nicht dargestellt) vorgesehen, so daß die oben erwähnten Informationen in den Informationsträger 5 des Transportgutes 1 geschrieben werden können. Jeder Bearbeitungseinrichtung 4 innerhalb des Transportsystems ist eine eindeutige Adresse zugeordnet.

Nachdem das Transportgut 1 aus der Lagereinrichtung 4a ausgelagert ist, wird dieses Transportgut 1 mittels der Fördereinrichtungen 2 weiter transportiert. An Verzweigungspunkten im Transportsystem, d.h. an den Verzweigungseinrichtungen 3 wird mittels einer Leseeinrichtung (nicht dargestellt) der Informationsträger 5 des Transportgutes 1 ausgelesen und damit die Information erhalten, die über das Ziel dieses Transportgutes 1 Auskunft gibt.

Anhand dieser aus dem Informationsträger 5 ausgelesenen Information (Zieladresse) und einer in der Verzweigungseinrichtung 3 intern abgespeicherten Zieladressenliste bestimmt die Verzweigungseinrichtung 3 die Richtung, in die das Transportgut 1 zu fördern ist.

Die in jeder Verzweigungseinrichtung 3 intern gespeicherte Zieladressenliste ist für diese Verzweigungseinrichtung 3 spezifisch und nicht flüchtig angelegt, so daß auch bei einem Stromausfall diese Zieladressenliste erhalten bleibt. Die Zieladressenliste enthält in hierarchischer Form sämtliche Ziele, die mittels dieser Verzweigungseinrichtung 3 erreichbar sind. Vorzugsweise sind dabei nur die Zieladressen in der Zieladressenliste gespeichert, die über diese Verzweigungseinrichtung 3 erreichbar sind, wenn die Verzweigungseinrichtung 3 nicht in Vorzugsrichtung eingestellt bzw. gedreht ist. Hierdurch wird eine Reduzierung der Menge der zu speichernden Informationen und damit eine Verkürzung der Zieladressenliste erreicht. Die Vorzugsrichtung jeder Verzweigungseinrichtung 3 ist dabei diejenige, in der ein Kreisen der Transportgüter 1 im Transportsystem gewährleistet ist, d.h. ein umlaufender Transport, der das Transportgut 1 immer wieder über die gleichen Verzweigungseinrichtungen 3 transportiert. Beispielsweise ist in der Figur die Vorzugsrichtung der linken unteren Verzweigungseinrichtung 3 durch einen Pfeil dargestellt.

Zusätzlich zu dieser Zieladressenliste kann in jeder Verzweigungseinrichtung 3 jeweils eine Suchliste, eine Feueralarmliste sowie eine Shutdownliste vorgesehen sein, deren Aufbau und Funktion weiter unten beschrieben wird.

Diese Ziellisten werden aktualisiert, wenn ein Teil eines Fertigungsbereiches ausfällt, eine Bearbeitungseinrichtung 4 ausfällt, eine Fördereinrichtung 2 ausfällt oder aber wenn sich der Aufbau des Transportsystems verändert (Hinzufügen oder Entfernen von Fertigungsbereichen, Verzweigungseinrichtungen 3, usw.).

Um den Durchlauf und den Transport der Transportgüter 1 im Transportsystem zu optimieren, kann in einer weiteren bevorzugten Ausführungsform nach der vorliegenden Erfindung die Einstellung der Verzweigungsrichtung der Verzweigungseinrichtungen 3 unter Berücksichtigung der Aktivität und/oder Verzweigungsrichtung von benachbarten Verzweigungseinrichtungen erfolgen. D.h., daß in einem komplexen Transportsystem, in dem mehrere alternative Routen zwischen aktueller Position und Ziel des Transportgutes 1 möglich sind, diejenige Route verfolgt werden kann, die auf dem kürzesten Weg und/oder der kürzesten Zeit zum Ziel führt. Hierzu werden, wie bereits oben angeführt, die Aktivitäten benachbarter und an einem alternativen Transportweg liegender Verzweigungseinrichtungen 3 bei der Einstellung der Verzweigungsrichtung an der aktuellen Position des Transportgutes 1 berücksichtigt und beispielsweise bereits stark frequentierte bzw. ausgelastete Verzweigungseinrichtungen 3 umgangen.

Unabhängig von der übergeordneten Steuerungseinrichtung wird also in Übereinstimmung mit dem Prinzip nach der vorliegenden Erfindung der Transport der Transportgüter 1 dezentral gesteuert durchgeführt. Nachdem ein bestimmtes Transportgut 1 aus der Lagereinrichtung 4a ausgelagert ist und in dem Informationsträger 5 des Transportgutes 1 die Zieladresse abgespeichert ist, wird dieses Transportgut 1 ohne weitere Eingriffe der Steuerungseinrichtung an das Ziel transportiert, indem die auf der Transportstrecke angeordneten Verzweigungseinrichtungen selbständig und anhand der internen Zieladressenliste die Verzweigungsrichtung festlegen, um das Transportgut 1 an das Ziel zu leiten.

Selbst bei einem Ausfall der Steuerungseinrichtung ist somit ein kontinuierlicher Betrieb des Transportsystems möglich, so daß die sich innerhalb des Transportsystems befindlichen Transportgüter 1 weiter gefördert werden können.

Sobald ein bestimmtes Transportgut 1 sein Ziel erreicht hat, d.h. an einer Bearbeitungseinrichtung 4 angekommen ist, wird dieses Transportgut 1 bei der Steuerungseinrichtung abgemeldet und nachdem die Bearbeitung durchgeführt worden ist, dieses Transportgut 1 wieder bei der Steuerungseinrichtung angemeldet, wobei gleichzeitig eine zweite Adresse als neue, erste Adresse in den Informationsträger 5 des Transportgutes 1 eingeschrieben wird, so daß ein neues Ziel angefahren werden kann.

Die Einspeicherung der zweiten Adresse im Informationsträger 5 kann entweder bereits zusammen mit der Speicherung der ersten Adresse bei der Auslagerung des Transportgutes 1 aus der Lagereinrichtung 4a erfolgen oder aber bei der Wiederanmeldung nach der Bearbeitung durch die Bearbeitungseinrichtung 4 bzw. bei dem Lift des Beispiels.

Im folgenden werden die oben erwähnten Listen beschrieben, die zusätzlich zu den Zieladressenlisten in den Verzweigungseinrichtungen 3 abgespeichert sein können:

Suchliste: Die Steuerungseinrichtung kann an jede Verzweigungseinrichtung 3 eine Suchliste übermitteln. Anhand dieser Suchliste kann jede Verzweigungseinrichtung 3 die durchlaufenden Transportgüter 1 überprüfen und falls ein bestimmtes Transportgut 1 an einer bestimmten Verzweigungseinrichtung 3 positioniert ist, diese Position an die Steuerungseinrichtung melden. Hierzu erhält jedes Transportgut 1 im Informationsträger 5 eine eindeutige Nummer. Sobald die Verzweigungseinrichtung 3 mittels der Leseeinrichtung den Informationsträger 5 des Transportgutes 1 ausgelesen hat und durch Vergleich mit der Suchliste festgestellt hat, daß die Position dieses Transportgut 1 an die Steuerungseinrichtung zu melden ist, wird die aktuelle Position dieses Transportgutes 1 über die Netzwerkverbindung an die Steuerungseinrichtung signalisiert.

Feueralarmliste: Falls im Fertigungsbereich ein Feueralarm ausgelöst wird und die Feuerschutztüren geschlossen werden, so kann in Abhängigkeit von entweder der Steuerungseinrichtung oder aber dem direkten Signal von den Feuerschutztüren eine spezielle Feueralarmliste in den Verzweigungseinrichtungen 3, die direkt vor den Feuerschutztüren angeordnet sind, aktiviert werden. Im letzteren Fall ist auch bei einem Ausfall der Steuerungseinrichtung eine sichere Reaktion bei Feueralarm möglich. Anhand der Feueralarmlisten können die Verzweigungseinrichtungen 3 die Transportgüter 1 umleiten bzw. geeignet weiterleiten.

Shutdownliste: In jeder Verzweigungseinrichtung 3 ist eine Zielliste für den Fall eines Herunterfahrens des Transportsystems gespeichert. Falls ein geplantes Herunterfahren durchgeführt wird, werden diese Shutdownlisten über die Steuerungseinrichtung aktiviert. Diese Shutdownlisten erlauben einen örtlich. begrenzten Shutdown (Herunterfahren bzw. Deaktivieren) in dem Transportsystem. Soll zum Beispiel der Fertigungsbereich A (in der Figur links oben) stillgelegt werden, beispielsweise für Wartungszwecke, Erweiterungen, etc.), so muß die davor liegende Verzweigungseinrichtung 3 entsprechend informiert bzw. aktiviert werden und auch die Verzweigungseinrichtungen 3, die sich innerhalb des Fertigungsbereiches A befinden, müssen ihre Shutdownlisten aktivieren, um die dort befindlichen Transportgüter 1 kontrolliert zu bewegen. Diese Shutdownlisten werden in Abhängigkeit vom Füllungsgrad der Lagereinrichtungen 4a ständig aktualisiert, so daß das System dezentral (d.h. in jeder Verzweigungseinrichtung 3) und jederzeit darüber informiert ist, ob die Lagerungskapazität innerhalb eines Fertigungsbereiches ausreicht, um im Falle eines Shutdowns sämtliche Transportgüter 1 in den dort vorhandenen Lagereinrichtungen 4a unterbringen zu können. Falls die Lagerungskapazitäten innerhalb des Fertigungsbereichs A nicht ausreichen sollten, kann durch eine entsprechende Aktualisierung der Shutdownlisten ein Teil der sich im Fertigungsbereich A befindlichen Transportgüter 1 aus dem Fertigungsbereich A heraus transportiert werden. Nach einem Shutdown und dem darauf folgenden Hochfahren können die sich im Fertigungsbereich auf den Fördereinrichtungen 2 befindlichen Transportgüter 1 weiter transportiert werden, ohne neu identifiziert werden zu müssen, da bei der nächsten Verzweigungseinrichtung 3 eine selbständige Weiterleitung erfolgt.

Für den Fall das im Fertigungsbereich die Stromversorgung ausfällt oder unterbrochen ist, bleiben die Transportgüter 1 auf den Fördereinrichtungen 2 stehen. Da die Ziellisten in den Verzweigungseinrichtungen 3 und auch die Adressen in den Informationsträgern 5 nicht flüchtig abgespeichert sind, (beispielsweise in einem EEPROM), können nach Wiederherstellung der Stromversorgung die Transportgüter 1 wieder weiter transportiert werden, ohne einen Eingriff durch die übergeordnete Steuerungseinrichtung.

Bei einem Ausfall der übergeordneten Steuerungseinrichtung können alle laufenden Transportaufträge abgearbeitet werden, da die entsprechenden Steuerungsinformationen dezentral in den Verzweigungseinrichtungen 3 und den Informationsträgern 5 der Transportgüter 1 abgespeichert sind. Neue Transportaufträge, die an den Lagereinrichtungen 4a in Auftrag gegeben werden, können bei einem Ausfall der übergeordneten Steuerungseinrichtung allerdings nur noch ohne Überwachung gestartet werden.

Zur Überwachung und Optimierung des gesamten Transportsystems ist es möglich, daß bei einer Auslagerung eines Transportgutes 1 aus einer Lagereinrichtung 4a ein entsprechendes Signal an die übergeordnete Steuerungseinrichtung geleitet wird; nach Erhalt dieses Signals startet die Steuerungseinrichtung einen Timer, d.h., daß die Zeit gemessen wird, die feststellt, ob dieses Transportgut 1 innerhalb einer vorbestimmten Zeitspanne bei ihrem Ziel angekommen ist. Sollte diese Zeitspanne zu lang sein, so setzt die Steuerungseinrichtung dieses Transportgut 1 (bzw. dessen Nummer) auf eine Fehlerliste.

Da die Ursachen für eine zulange Zeitspanne zwischen Auslagerung und Erreichen des Zieles vielfältig sein können, wird beispielsweise bei einem teilweise fehlerhaften Informationsträger 5 die korrekte Verzweigung an den Verzweigungseinrichtungen 3 nicht mehr möglich sein, so daß das zugehörige Transportgut 1 ständig in Vorzugsrichtung (wie anfangs beschrieben) der Verzweigungseinrichtungen 3 auf den Fördereinrichtungen 2 kreist. Ein solcher fehlerhafter Informationsträger 5 verhindert zum Beispiel das Auslesen der Zieladresse, so daß die Verzweigungseinrichtung 3 in Vorzugsrichtung dreht. Ein solchermaßen ständig im Kreis transportiertes Transportgut 1 kann mittels der Fehlerliste identifiziert und schließlich manuell aus dem Transportsystem entfernt werden oder zu einem Standardfehlerziel bewegt werden. Ein anderer Fall für eine zulange Zeitspanne zwischen Auslagerung und Erreichen des Zieles kann vorliegen, wenn beispielsweise die Leseeinrichtung einer Verzweigungseinrichtung 3 ausfällt. Da dann ebenfalls die Verzweigungseinrichtung 3 in Vorzugsrichtung geschaltet ist, ist ein korrekter Transport in einer bestimmten Richtung, die nicht die Vorzugsrichtung ist, nicht mehr möglich. Das Transportgut 1 kreist dann ebenfalls, bis entweder die Leseeinrichtung der entsprechenden Verzweigungseinrichtung 3 wieder funktioniert oder aber bis das Transportgut 1 ebenso manuell entfernt wird oder zu einem Standardfehlerziel bewegt werden.

Nachdem ein Transportgut 1 eine abschließende Bearbeitung an einer Bearbeitungseinrichtung 4 eines Fertigungsbereiches (in der Figur z.B. "A") durchlaufen hat, wieder in den Transport-Kreislauf zurückgesetzt ist und beim System angemeldet ist, wie weiter oben beschrieben, wird dieses Transportgut 1 zum nächsten Ziel gefördert. Dieses neue Ziel ist in Übereinstimmung mit einer Ausführungsform nach der vorliegenden Erfindung ein weiterer Fertigungsbereich (Bay), so daß die oben erwähnte zweite Adresse der Name eines Fertigungsbereiches (z.B. "B") ist.

Erreicht das so zu einem weiteren Fertigungsbereich B geförderte Transportgut 1 die erste Lagereinrichtung 4a dieses Fertigungsbereiches B, so wird dieses Transportgut 1 in diese erste Lagereinrichtung 4a eingelagert, sofern darin ein Platz vorhanden ist. Ist in dieser ersten Lagereinrichtung 4a kein Platz vorhanden, so wird das Transportgut 1 zu der nächsten Lagereinrichtung 4a dieses Fertigungsbereiches B transportiert und dort eingelagert, sofern ein Platz vorhanden ist. Auf die gleiche Art und Weise werden sämtliche Lagereinrichtungen 4a dieses Fertigungsbereiches B angesteuert, bis das Transportgut 1 wieder bei der ersten Lagereinrichtung 4a dieses Fertigungsbereiches B ankommt, falls alle Lagereinrichtungen 4a belegt sind. Auch hierbei ist über den Timer gewährleistet, daß die Trägereinrichtung 1 nach Überschreiten einer bestimmten Zeitspanne auf die Fehlerliste gesetzt wird. In einer weiteren Ausführungsform kann die letzte in Transportrichtung liegende Lagereinrichtung 4a automatisch das im Informationsträger 5 des Transportgutes 1 gespeicherte Ziel mit dem nächsten Fertigungsbereich überschreiben, wenn ein längeres Kreisen nicht erwünscht ist.

Das Aus- und Einlagern aus der und in die Lagereinrichtung 4a läuft dabei wie folgt ab: bei der Auslagerung eines Transportgutes 1 aus der Lagereinrichtung 4a wird die zugehörige Fördereinrichtung 2 kurzzeitig angehalten, um Kollisionen mit fahrenden Transportgütern 1 zu vermeiden. Bei der Einlagerung eines Transportgutes 1 in die Lagereinrichtung 4a wird dieses Transportgut 1 auf der Fördereinrichtung 2 kurzzeitig angehalten, wenn die Lagereinrichtung 4a signalisiert hat, daß ein Platz frei ist. Hierzu ist vor der Lagereinrichtung 4a eine Leseeinrichtung und eine Schreibeinrichtung für den Informationsträger 5 des Transportgutes 1 vorgesehen. Vorteilhafterweise kann dann, wenn sämtliche Lagereinrichtungen 4a eines Fertigungsbereiches belegt sind, der Informationsträger 5 der Trägereinrichtung 1 neu beschrieben werden und diese Trägereinrichtung 1 zu einem anderen Fertigungsbereich geschickt werden, wobei diese Anweisung durch die übergeordnete Steuereinrichtung oder die letzte in Transportrichtung liegende Lagereinrichtung 4a gegeben wird.

Die Vorteile einer solchen Aus- und Einlagerungs-Technik sind, daß, wenn der Timer dementsprechend eingestellt ist, die Transportgüter 1 mehrere Runden in den jeweiligen Fertigungsbereichen drehen können und auch noch in einer späteren Runde einen Platz in einer Lagereinrichtung 4a finden können. Hierdurch wird eine sehr gute Auslastung der Lagereinrichtungen 4a und eine erhöhte Transportkapazität der Fördereinrichtungen 2 sichergestellt.

Die Robustheit des Transportsystems und der Steuerung des Transportsystems ergibt sich aus der dezentralen Steuerung des Transportes der Transportgüter 1 mittels der an den Transportgütern 1 vorgesehenen Informationsträger 5 und den Verzweigungseinrichtungen 3, die über entsprechende Leseeinrichtungen verfügen. Sobald die Zieladressen der Transportgüter 1 eingespeichert sind, ist eine selbständige Ansteuerung der jeweiligen Ziele möglich, ohne einen Eingriff durch die übergeordnete Steuerungseinrichtung. Somit ist eine Steuerung der untersten Ebene realisiert, die gegenüber bisher realisierten Systemen dem Stand der Technik deutliche Vorteile aufweist. Diese Vorteile werden weiter unten zusammengefaßt dargestellt.

Die Aufgaben der übergeordneten Steuerungseinrichtung lassen sich wie folgt definieren: Erteilung von Transportaufträgen an die Lagereinrichtungen 4a; die Zählung der Transportaufträge je Bearbeitungseinrichtung 4; die Konfiguration der Suchlisten der Verzweigungseinrichtungen 3; die Überwachung der Timer und das Führen der Fehlerlisten; das Umkonfigurieren und/oder das Aktivieren der Ziellisten im Fehlerfall; die Kommunikation mit den Feuerschutztüren; die Fernkonfiguration der Steuerlogik in den Verzweigungseinrichtungen 3 und den Bearbeitungseinrichtungen 4 (Lifte); sowie die Kommunikation mit höheren Steuerungssystemen).

Um zu gewährleisten, daß die Transportgüter 1 bei den einzelnen Bearbeitungseinrichtungen 4 in der richtigen Reihenfolge ankommen, unabhängig von den Unterschieden in den Wegstrecken der einzelnen Transportgüter 1, wird für jede Bearbeitungseinrichtung 4 ein Zähler vorgesehen und jeweils um Eins [1] erhöht. Diese Zahl wird zusammen mit dem Transportauftrag an die Lagereinrichtung 4a übermittelt und gemeinsam mit der ersten Zieladresse in den Informationsträger 5 des Transportgutes 1 geschrieben. Erreicht dieses Transportgut 1 das Ziel, so wird von der dort installierten Leseeinrichtung der Informationsträger 5 ausgelesen und die Nummer/Zahl des Transportauftrages festgestellt; diese Nummer wird mit der Nummer des zuletzt bearbeiteten Transportgutes 1 verglichen. Ist die neue Nummer um Eins größer als die alte Nummer, so ist die Reihenfolge des Transportgutes 1 in Ordnung und die Bearbeitung kann erfolgen. Ist jedoch die Differenz zwischen der alten Nummer und der neuen Nummer größer Eins, so wird dieses Transportgut 1 in eine Warteschleife geschickt und die Bearbeitungseinrichtung 4 wartet auf das richtige Transportgut 1. Durch diesen Vergleich der Transportauftragsnummern können Transportaufträge an den Lagereinrichtungen 4a gestartet werden, ohne Rücksicht darauf, ob die Reihenfolge bei den Bearbeitungseinrichtungen 4 eingehalten ist, da die Bearbeitungseinrichtungen 4 selbständig für die Einhaltung der korrekten Reihenfolge sorgen und zu früh eintreffende Transportgüter 1 in die Warteschleife schicken. Es ergibt sich durch diese Steuerung eine Verkürzung der Anlieferzeiten. Ist die Reihenfolge der Bearbeitung eines Transportgutes 1 ohne Bedeutung, so wird diesem Transportgut 1 die Nummer 0 [Null] zugewiesen, so daß die Bearbeitungseinrichtungen 4 erkennen können, daß dieses Transportgut 1 in beliebiger Reihenfolge bearbeitet werden kann.

Um zu verhindern, daß eine fehlendes Transportgut 1 (d.h. das nächste in der Reihenfolge) eine Bearbeitungseinrichtung 4 blockiert, da diese ständig auf dieses Transportgut 1 mit der passenden Folgenummer wartet, wird nach Verstreichen einer vorbestimmten Zeitspanne die Zählung dieser Bearbeitungseinrichtung 4 bzw. der zugehörigen Verzweigungseinrichtung 3 neu initialisiert.

Die Vorteile des erfindungsgemäßen Transportsystems bzw. des Verfahrens zur Steuerung des Transportsystems sind wie folgt:

Bei einem Ausfall einer Leseeinrichtung einer Verzweigungseinrichtung 3 oder bei einem defekten Informationsträger 5 eines Transportgutes 1 geht das Transportgut 1 nicht verloren, sondern kreist solange in dem Transportsystem in Vorzugsrichtung, bis die Leseeinrichtung wieder funktioniert oder die Transportgut 1 manuell von der Fördereinrichtung 2 genommen wird bzw. zu einem Standardfehlerziel bewegt wird. Das Restsystem arbeitet ohne Beeinträchtigung weiter.

Bei einem Hochfahren des Systems nach einem Abschalten oder nach einem Stromausfall ergeben sich keine Probleme, da die für den Transport erforderlichen Daten in den nicht flüchtigen Informationsträgern 5 der Transportgüter 1 gespeichert sind.

Änderungen (Erweiterung, Entfernung von einzelnen Bearbeitungseinrichtungen 4 oder ganzen Fertigungsbereichen A, B; Einbau zusätzlicher Verzweigungseinrichtungen 3) des Aufbaus des Transportsystems sind jederzeit möglich.

Im Falle eines Feueralarms ist eine einfache Lösung vorgesehen, so daß durch das Schließen der Feuerschutztüren keine Transportprobleme auftreten können.

Falls die übergeordnete Steuerungseinrichtung ausfällt oder aber die Netzwerkanbindung gestört ist, werden laufende Transportaufträge nicht beeinträchtigt und das Abschicken weiterer Trägereinrichtungen 1 von den Bearbeitungseinrichtungen 4 in Richtung der Lagereinrichtungen 4a und von den Lagereinrichtungen 4a zu den Bearbeitungseinrichtungen 4 ist weiterhin möglich (wenn auch ohne Überwachung).

Ein örtlich begrenztes Abschalten (Shutdown) des Transportsystems ist möglich.

Falls eine Bearbeitungseinrichtung 4 ausfallen sollte, ist durch Änderung der Zieladressenliste eine schnelle und einfache Reaktion möglich.

Die Steuerung des physischen Transportvorganges ist von der übergeordneten Logistik entkoppelt.

Die Steuerung der Bewegung des Transportgutes 1 zwischen Lagereinrichtung 4a und Bearbeitungseinrichtung 4 erfolgt dezentral und unabhängig von der übergeordneten Steuerungseinrichtung.

Die anfallende und zu übertragende Datenmenge innerhalb des Transportsystems wird auf ein Minimum reduziert.

Im Normalfall läuft der Transport zwischen Auftrag an die (Start-) Lagereinrichtung 4a und Wiedereintreffen des Transportgutes 1 bei der folgenden Lagereinrichtung 4a ohne Eingreifen der übergeordneten Steuerungseinrichtung ab.

Das Transportsystem ist jederzeit und auch gebäudeübergreifend erweiterbar.

Über die Timer ist eine Erfassung der Transportzeiten möglich.

Durch Einstellung der Anzahl der gleichzeitig möglichen Transportaufträge pro Bearbeitungseinrichtung (Anzahl der möglichen Folgenummern in der Reihenfolge) ist eine einfache Kontrolle der Belastung bzw. Auslastung der Fördereinrichtungen möglich.

Alternatives Routing ist möglich.

Die richtige Reihenfolge der Anlieferung der Transportgüter 1 an einer Bearbeitungseinrichtung 4 ist unabhängig von der zurückgelegten Wegstrecke gewährleistet.

Die Fördereinrichtungen 2 können als Zwischenlager genutzt werden, ohne die Steuerung zu belasten.

Die Programme zur Steuerung der einzelnen Verzweigungseinrichtungen 3 betreffen nur einen kleinen, überschaubaren Teilmenge des Transportsystems, so daß diese einfach zu entwickeln und zu warten sind.

Ein Transportsystem in Übereinstimmung mit der vorliegenden Erfindung, die im Ausführungsbeispiel zum Transport von Wafern eingesetzt wird, umfaßt eine Vielzahl von Transportgütern (im Beispiel Trägereinrichtungen, die die Wafer aufnehmen), eine Vielzahl von Fördereinrichtungen, die die Transportgüter transportieren, eine Vielzahl von Verzweigungseinrichtungen, die die Transportgüter zu unterschiedlichen Fördereinrichtungen verzweigen, eine Vielzahl von Bearbeitungseinrichtungen, an denen die Transportgüter (im Beispiel Wafer) bearbeitet werden, und eine Vielzahl von Lagereinrichtungen, in denen die Transportgüter (im Beispiel Trägereinrichtungen mit den Wafern) zwischengelagert werden, wobei jedes Transportgut einen Informationsträger aufweist, in dem zumindest eine erste Zieladresse gespeichert ist, so daß das Transportgut zu einer bestimmten, dieser Zieladresse entsprechenden Bearbeitungseinrichtung transportierbar ist, diese erste Zieladresse an jedem Ein- bzw. Ausgang des Transportsystems (im Beispiel an den Liften) an einer Bearbeitungseinrichtung gelesen wird und nach der Bearbeitung an den Ein- bzw. Ausgängen eine zweite Zieladresse geschrieben wird, und jede Verzweigungseinrichtung mittels einer internen Zieladressenliste die Verzweigungsrichtung festlegt, indem an jeder Verzweigungseinrichtung der Informationsträger jedes Transportgutes ausgelesen wird. Ein wesentlicher Teil der Steuerung des Transportsystems, d.h. die Transportverfolgung der Transportguten erfolgt dabei dezentral und auf der untersten Steuerungsebene, wodurch das System robuster ausgebildet ist.

Zusammenfassend wird nach der vorliegenden Erfindung vorgeschlagen, daß die reine Transportverfolgung der Trägereinrichtungen 1 auf eine unterste Steuerungsebene verlagert wird, so daß das System gegenüber auftretenden Fehlern robuster ausgebildet ist. Die übergeordnete Steuerungseinrichtung ist entlastet und bei einem Ausfall dieser Steuerungseinrichtung können die darunter angeordneten Steuerungsbereiche selbständig weiter arbeiten und die laufenden Transportaufträge ausführen und zu Ende bringen.

## Patentansprüche

1. Transportsystem, **mit**
einer Vielzahl von Transportgüter (1),
einer Vielzahl von Fördereinrichtungen (2), die die Transportgüter (1) transportieren,
einer Vielzahl von Verzweigungseinrichtungen (3), die die Transportgüter (1) zu unterschiedlichen Fördereinrichtungen (2) verzweigen,
einer Vielzahl von Ein- bzw. Ausgängen an Bearbeitungseinrichtungen (4), an denen die Transportgüter bearbeitet werden, und
einer Vielzahl von Lagereinrichtungen (4a), in denen die Transportgüter zwischengelagert werden (1), **wobei**
jedes Transportgut (1) einen Informationsträger (5) aufweist, in dem zumindest eine erste Zieladresse gespeichert ist, so daß das Transportgut zu einer bestimmten, dieser Zieladresse entsprechenden Bearbeitungseinrichtung (4) transportierbar ist,
diese erste Zieladresse an jedem Ein- bzw. Ausgang an einer Bearbeitungseinrichtung (4) gelesen wird und nach der Bearbeitung eine zweite Zieladresse geschrieben wird, und
jede Verzweigungseinrichtung (3) mittels einer internen Zieladressenliste die Verzweigungsrichtung festlegt, indem an jeder Verzweigungseinrichtung (3) der Informationsträger (5) jedes Transportgutes (1) ausgelesen wird.

2. Transportsystem nach Anspruch 1, wobei die zweite Zieladresse einem Fertigungsbereich (B) entspricht und das Transportgut (1) nach der Bearbeitung an der ersten Zieladresse zu einer ersten Lagereinrichtung (4a) dieses Fertigungsbereiches (B) transportiert wird.

3. Transportsystem nach Anspruch 2, wobei, wenn die erste Lagereinrichtung (4a) dieses Fertigungsbereiches (B) belegt ist, das Transportgut (1) sukzessive alle anderen Lagereinrichtungen (4a) dieses Fertigungsbereiches (B) ansteuert, bis ein freier Lagerplatz erreicht ist.

4. Transportsystem nach Anspruch 3, wobei die Transportgut (1) in diesem Fertigungsbereich (B) im Kreis transportiert wird, falls alle Lagereinrichtungen (4a) belegt sind.

5. Transportsystem nach einem der Ansprüche 1 bis 4, wobei die Zieladressenliste in jeder Verzweigungseinrichtung (3) spezifisch aufgebaut ist und sämtliche über diese Verzweigungseinrichtung (3) erreichbare Ziele umfaßt.

6. Transportsystem nach einem der Ansprüche 1 bis 4, wobei die Zieladressenliste nur die Ziele umfaßt, die nicht in einer Vorzugsrichtung der Verzweigungseinrichtung (3) zu erreichen sind.

7. Transportsystem nach einem der Ansprüche 1 bis 6, wobei jede Verzweigungseinrichtung (3) zusätzlich die Aktivitäten benachbarter Verzweigungseinrichtungen (3) berücksichtigt, wenn die Verzweigungsrichtung bestimmt wird, um die Transportstrecke zu optimieren.

8. Transportsystem nach einem der Ansprüche 1 bis 7, wobei der Inhalt des Informationsträgers (5) nicht flüchtig ist.

9. Transportsystem nach einem der Ansprüche 1 bis 8, wobei jede Verzeigungseinrichtung (3) eine Leseeinrichtung aufweist, um den Informationsträger (5) auszulesen.

10. Transportsystem nach einem der Ansprüche 1 bis 9, wobei jeder Ein- bzw. Ausgang an einer Bearbeitungseinrichtung (4) eine Leseeinrichtung und eine Schreibeinrichtung für den Informationsträger (5) aufweist.

11. Transportsystem nach einem der Ansprüche 1 bis 10, wobei jede Verzweigungseinrichtung (3) zusätzliche Adressenlisten umfaßt, die in Ausnahmesituationen, wie Feueralarm, Abschaltung des Transportsystems und Teilabschaltung des Transportsystems aktivierbar sind.

12. Transportsystem nach einem der Ansprüche 1 bis 11, wobei die Zieladressenlisten und die zusätzlichen Adressenlisten kontinuierlich aktualisiert werden, um Veränderungen im Aufbau der Transportsystem laufend zu erfassen.

13. Transportsystem nach einem der Ansprüche 1 bis 12, wobei ein Transportauftrag durch Auslagerung des Transportgutes (1) aus der Lagereinrichtung (4a) aufgenommen wird, der Informationsträger (5) dieses Transportgutes (1) mit den Zieladressen beschrieben wird, dieses Transportgut (1) mittels der Fördereinrichtungen (2) transportiert wird und mittels der Verzweigungseinrichtungen (3) in Richtung zur ersten Zieladresse verzweigt wird, wobei nach Erreichen der ersten Zieladresse entsprechenden Bearbeitungseinrichtung (4) die Bearbeitung durchgeführt wird und danach das Transportgut (1) mit der zweiten Zieladresse versehen wird, um weiter transportiert zu werden.

14. Transportsystem nach Anspruch 13, wobei, falls die Zeitspanne zwischen Auslagerung und Bearbeitung größer als eine vorbestimmte Zeitdauer ist, dieses Transportgut (1) auf eine Fehlerliste gesetzt wird.

15. Transportsystem nach Anspruch 14, wobei jedem Transportgut (1) eine eindeutige Nummer zugewiesen ist, die ebenfalls im Informationsträger (5) abgespeichert ist und wobei diese Nummer in die Fehlerliste eingetragen wird.

16. Verfahren zur Steuerung des Transportsystems nach einer der Ansprüche 1-15 mit den folgenden Schritten:
Auslagern eines Transportgutes (1) aus einer Lagereinrichtung (4a),
Einspeichern von zumindest einer ersten Zieladresse in einen Informationsträger (5) des Transportgutes (1),
Transportieren des Transportgutes (1) mittels einer Vielzahl von Fördereinrichtungen (2), wobei
eine Vielzahl von Verzweigungseinrichtungen (3) zwischen den Fördereinrichtungen (2) vorgesehen ist, um die Transportgüter (1) zu unterschiedlichen Fördereinrichtungen (2) zu verzweigen,
Auslesen der Zieladresse aus dem Informationsträger (5) des Transportgutes (1) an jeder Verzweigungseinrichtung (3),
Vergleichen der gelesenen Zieladresse mit einer internen Zieladressenliste in der Verzweigungseinrichtung (3),
Einstellen der Verzweigungsrichtung der Verzweigungseinrichtung (3) in Abhängigkeit von dem Ergebnis dieses Vergleiches, so daß das Transportgut (1) in Richtung der ersten Zieladresse verzweigt wird,
Wiederholen der Schritte Transportieren/Auslesen/Vergleichen/Einstellen, bis eine der Zieladresse entsprechende Bearbeitungseinrichtung (4) erreicht ist,
Bearbeiten des Transportgutes (1),
Einspeichern und/oder Lesen einer zweiten Zieladresse in den bzw. aus dem Informationsträger (5), um das Transportgut (1) zu einem nächsten Fertigungsbereich weiter zu transportieren.

17. Verfahren nach Anspruch 16, wobei die interne Zieladressenliste sämtliche über diese Verzweigungseinrichtung (3) erreichbaren Ziele umfaßt.

18. Verfahren nach Anspruch 16 oder 17, wobei die zweite Zieladresse zusammen mit der ersten Zieladresse in den Informationsträger (5) bei der Auslagerung geschrieben wird und nach der Bearbeitung die erste Zieladresse durch die zweite Zieladresse ersetzt bzw. überschrieben wird.

19. Verfahren nach einem der Ansprüche 16 bis 18, wobei die Verzweigungseinrichtung (3) mittels der internen Zieladressenliste die Verzweigungsrichtung ermittelt, unabhängig von einer übergeordneten Steuerungseinrichtung.

20. Verfahren nach Anspruch 19, wobei die übergeordnete Steuerungseinrichtung eine Aktualisierung der Zieladressenliste in den Verzweigungseinrichtungen (3) durchführt, wenn sich die Konfiguration des Transportsystems verändert.

21. Verfahren nach einem der Ansprüche 16 bis 20, wobei zusätzlich zu den Zieladressenlisten weitere Adressenlisten in den Verzweigungseinrichtungen (3) abgelegt sind, die in Ausnahmefällen, wie Feueralarm oder (Teil-) Abschaltung des Transportsystems aktivierbar sind.

22. Verfahren nach einem der Ansprüche 16 bis 21, wobei nach Erreichen der letzten in einem bestimmten Fertigungsbereich verfügbaren Lagereinrichtung (4a) die Zielinformation im Informationsträger (5) des Transportgutes (1) von der Lagereinrichtung mit dem nächsten Fertigungsbereich überschrieben wird, falls im ursprünglich vorgesehenen Fertigungsbereich kein Lagerplatz gefunden wurde.

## Claims

1. Transport system, having
a multiplicity of transported goods (1),
a multiplicity of conveying devices (2) which transport the transported goods (1),
a multiplicity of branching devices (3), which branch the transported goods (1) to different conveying devices (2)
a multiplicity of inputs and outputs to processing devices (4), on which the transported goods are processed, and
a multiplicity of storage devices (4a), in which the transported goods are temporarily stored (1), where
each item of transported goods (1) has an information carrier (5) in which at least a first destination address is stored, so that the transported goods can be transported to a specific processing device (4) corresponding to this destination address,
this first destination address is read at each input and output to and from a processing device (4) and, after the processing, a second destination address is written, and
each branching device (3) defines the branching direction by means of an internal destination address list, by the information carrier (5) of each item of transported goods (1) being read out at each branching device (3).

2. Transport system according to Claim 1, the second destination address corresponding to a fabrication area (B), and the item of transported goods (1), after being processed at the first destination address, being transported to a first storage device (4a) belonging to this fabrication area (B).

3. Transport system according to Claim 2, where, if the first storage device (4a) of this fabrication area (B) is occupied, the item of transported goods (1) successively selects all the other storage devices (4a) belonging to this fabrication area (B) until a free storage space is reached.

4. Transport system according to Claim 3, the item of transported goods (1) being transported in a circle in this fabrication area (B) if all the storage devices (4a) are occupied.

5. Transport system according to one of Claims 1 to 4, the destination address list being built up specifically in each branching device (3) and comprising all the destinations which can be reached via this branching device (3).

6. Transport system according to one of Claims 1 to 4, the destination address list comprising only the destinations which cannot be reached in a preferred direction of the branching device (3).

7. Transport system according to one of Claims 1 to 6, each branching device (3) additionally taking account of the activities of adjacent branching devices (3), when the branching direction is determined, in order to optimize the transport path.

8. Transport system according to one of Claims 1 to 7, the contents of the information carrier (5) being non-volatile.

9. Transport system according to one of Claims 1 to 8, each branching device (3) having a reading device in order to read out the information carrier (5).

10. Transport system according to one of Claims 1 to 9, each input and output to and from a processing device (4) having a reading device and a writing device for the information carrier (5).

11. Transport system according to one of Claims 1 to 10, each branching device (3) comprising additional address lists which can be activated in exceptional situations, such as a fire alarm, the switching off of the transport system and the partial switching off of the transport system.

12. Transport system according to one of Claims 1 to 11, the destination address lists and the additional address lists being updated continuously in order to register changes in the structure of the transport system continuously.

13. Transport system according to one of Claims 1 to 12, a transport task being taken up by removing the item of transported goods (1) from the storage device (4a), writing the destination addresses to the information carrier (5) of this item of transported goods (1), this item of transported goods (1) being transported by means of the conveying devices (2) and branched in the direction of the first destination address by means of the branching devices (3), the processing being carried out after the processing device (4) corresponding to the first destination address has been reached, and the item of transported goods (1) then being provided with the second destination address in order to be transported onwards.

14. Transport system according to Claim 13, where, if the time interval between removal from storage and processing is greater than a predetermined time period, this item of transported goods (1) is placed on a fault list.

15. Transport system according to Claim 14, each item of transported goods (1) being allocated a unique number, which is likewise stored in the information carrier (5), and this number being entered into the fault list.

16. Method of controlling the transport system according to one of Claims 1-15, having the following steps:
removing an item of transported goods (1) from a storage device (4a),
storing at least a first destination address in an information carrier (5) belonging to the item of transported goods (1),
transporting the item of transported goods (1) by means of a multiplicity of conveying devices (2),
a multiplicity of branching devices (3) being provided between the conveying devices (2) in order to branch the transported goods (1) to different conveying devices (2),
reading out the destination address from the information carrier (5) belonging to the item of transported goods (1) at each branching device (3),
Comparing the read destination address with an internal destination address list in the branching device (3),
setting the branching direction of the branching device (3) on the basis of the result of this comparison, so that the item of transported goods (1) is branched in the direction of the first destination address,
repeating the steps of transporting/reading out/comparison/setting until a processing device (4) corresponding to the destination address is reached,
processing the item of transported goods (1), storing and/or reading a second destination address in or from the information carrier (5), in order to transport the item of transported goods (1) onwards to a next fabrication area.

17. Method according to Claim 16, the internal destination address list comprising all the destinations which can be reached via this branching device (3).

18. Method according to Claim 16 or 17, the second destination address, together with the first destination address, being written in the information carrier (5) as it is removed from store and, following the processing, the first destination being replaced or overwritten by the second destination address.

19. Method according to one of Claims 16 to 18, the branching device (3) determining the branching direction by means of the internal destination address list, independently of a higher-order control device.

20. Method according to Claim 19, the higher-order control device updating the destination address list in the branching devices (3) if the configuration of the transport system is changed.

21. Method according to one of Claims 16 to 20, in addition to the destination address lists, further address lists being stored in the branching devices (3) and being capable of activation in exceptional cases, such as a fire alarm or (partial) switching off of the transport system.

22. Method according to one of Claims 16 to 21, where, after the last storage device (4a) available in a specific fabrication area has been reached, the destination information in the information carrier (5) of the item of transported goods (1) being overwritten with the next fabrication area by the storage device if no storage space has been found in the fabrication area originally envisaged.

## Revendications

1. Système de transport, comprenant
une pluralité de produits (1) transportés,
une pluralité de convoyeurs (2), qui transportent les produits (1),
une pluralité d'embranchements (3), qui dirigent les produits (1) transportés vers différents convoyeurs (2),
une pluralité d'entrées/sorties aux dispositifs (4) de traitement où les produits (1) transportés sont traités, et
une pluralité de dispositifs (4a) d'entreposage où les produits (1)
transportés sont temporairement entreposés,
dans lequel
chaque produit (1) transporté comporte un support (5) d'informations sur lequel est mémorisée au moins une première adresse de destination, de sorte que le produit peut être transporté vers un dispositif (4) de traitement donné, correspondant à cette adresse de destination,
cette première adresse de destination est lue à chaque entrée/sortie d'un dispositif (4) de traitement, et une deuxième adresse de destination est écrite à la suite du traitement, et
chaque embranchement (3) détermine la direction à prendre au moyen d'une liste interne d'adresses de destination, par le fait que le support
(5) d'informations de chaque produit (1) transporté est lu à chaque embranchement (3).

2. Système de transport suivant la revendication 1, dans lequel la deuxième adresse de destination correspond à une zone (B) de fabrication, et le produit (1) transporté est, après son traitement à la première adresse de destination, transporté vers un premier dispositif (4a) d'entreposage de cette zone (B) de fabrication.

3. Système de transport suivant la revendication 2, dans lequel, si le premier dispositif (4a) d'entreposage de cette zone (B) de fabrication est occupé, le produit (1) transporté se dirige successivement vers tous les autres dispositifs (4a) d'entreposage de cette zone (B) de fabrication, jusqu'à ce qu'une place d'entreposage libre soit atteinte.

4. Système de transport suivant la revendication 3, dans lequel le produit (1) est transporté en cercle dans cette zone (B) de fabrication si tous les dispositifs (4a) d'entreposage sont occupés.

5. Système de transport suivant l'une des revendications 1 à 4, dans lequel la liste d'adresses de destination est construite de façon spécifique dans chaque embranchement (3), et comprend toutes les destinations pouvant être atteintes au moyen de cet embranchement (3).

6. Système de transport suivant l'une des revendications 1 à 4, dans lequel la liste d'adresses de destination comprend uniquement les destinations qui ne peuvent pas être atteintes dans une direction privilégiée de l'embranchement (3).

7. Système de transport suivant l'une des revendications 1 à 6, dans lequel chaque embranchement (3) tient en outre compte des activités des embranchements (3) voisins pour la détermination de la direction à prendre, afin d'optimiser le parcours de transport.

8. Système de transport suivant l'une des revendications 1 à 7, dans lequel le contenu du support (5) d'informations n'est pas volatil.

9. Système de transport suivant l'une des revendications 1 à 8, dans lequel chaque embranchement (3) comporte un dispositif de lecture afin de lire le support (5) d'informations.

10. Système de transport suivant l'une des revendications 1 à 9, dans lequel chaque entrée/sortie d'un dispositif (4) de traitement comporte un dispositif de lecture et un dispositif d'écriture pour le support (5) d'informations.

11. Système de transport suivant l'une des revendications 1 à 10, dans lequel chaque embranchement (3) comporte des listes d'adresses supplémentaires, qui peuvent être activées dans des situations exceptionnelles telles qu'alarme incendie, arrêt du système de transport et arrêt partiel du système de transport.

12. Système de transport suivant l'une des revendications 1 à 11, dans lequel les listes d'adresses de destination et les listes d'adresses supplémentaires sont actualisées en continu, afin d'enregistrer en permanence les modifications de la structure du système de transport.

13. Système de transport suivant l'une des revendications 1 à 12, dans lequel une mission de transport est prise en charge par le déstockage du produit (1) transporté du dispositif (4a) d'entreposage, les adresses de destination sont écrites sur le support (5) d'informations de ce produit (1) transporté, ce produit (1) est transporté au moyen des convoyeurs (2) et, par l'intermédiaire des embranchements (3), dirigé vers la première adresse de destination, le traitement est effectué une fois atteint le dispositif (4) de traitement correspondant à la première adresse de destination, puis le produit (1) transporté est pourvu de la deuxième adresse de destination, afin d'être transporté plus loin.

14. Système de transport suivant la revendication 13, dans lequel, si l'intervalle de temps entre le déstockage et le traitement est supérieur à une durée prescrite, ce produit (1) transporté est inscrit dans une liste de défaillances.

15. Système de transport suivant la revendication 14, dans lequel un numéro univoque est attribué à chaque produit (1) transporté, ce numéro étant également mémorisé dans le support (5) d'informations, et étant inscrit dans la liste de défaillances.

16. Procédé de commande du système de transport suivant l'une des revendications 1 à 15, comprenant les étapes suivantes :
déstockage d'un produit (1) transporté d'un dispositif (4a) d'entreposage,
enregistrement d'au moins une première adresse de destination sur un support (5) d'informations du produit (1) transporté,
transport du produit (1) au moyen d'une pluralité de convoyeurs (2),
une pluralité d'embranchements (3) étant prévus entre les convoyeurs (2), afin de diriger les produits (1) transportés vers différents convoyeurs (2),
lecture, à chaque embranchement (3), de l'adresse de destination sur le support (5) d'informations du produit (1) transporté,
comparaison de l'adresse de destination lue avec une liste interne d'adresses de destination dans l'embranchement (3),
réglage de la direction à prendre à l'embranchement (3) en fonction du résultat de cette comparaison, de sorte que le produit (1) transporté est dirigé vers la première adresse de destination,
répétition des étapes de transport/lecture/comparaison/réglage jusqu'à l'atteinte d'un dispositif (4) de traitement correspondant à l'adresse de destination,
traitement du produit (1) transporté,
enregistrement et/ou lecture d'une deuxième adresse de destination sur le support (5) d'informations, afin de transporter le produit (1) transporté plus loin, vers la zone de fabrication suivante.

17. Procédé suivant la revendication 16, suivant lequel la liste interne d'adresses de destination comprend toutes les destinations pouvant être atteintes au moyen de cet embranchement (3).

18. Procédé suivant la revendication 16 ou 17, suivant lequel la deuxième adresse de destination est écrite conjointement avec la première adresse de destination sur le support (5) d'informations lors du déstockage, et la première adresse de destination est remplacée ou encore écrasée par la deuxième adresse de destination à la suite du traitement.

19. Procédé suivant l'une des revendications 16 à 18, suivant lequel l'embranchement (3) détermine la direction à prendre au moyen de la liste interne d'adresses de destination, indépendamment d'un dispositif de commande de niveau supérieur.

20. Procédé suivant la revendication 19, suivant lequel le dispositif de commande de niveau supérieur effectue une actualisation des listes d'adresses de destination dans les embranchements (3) si la configuration du système de transport est modifiée.

21. Procédé suivant l'une des revendications 16 à 20, suivant lequel des listes d'adresses supplémentaires sont enregistrées en plus des listes d'adresses de destination dans les embranchements (3) et peuvent être activées dans des situations exceptionnelles telles qu'alarme incendie ou arrêt (partiel) du système de transport.

22. Procédé suivant l'une des revendications 16 à 21, suivant lequel, à l'atteinte du dernier dispositif (4a) d'entreposage disponible dans une zone de fabrication donnée, l'information de destination sur le support (5) d'informations du produit (1) transporté est écrasée par le dispositif d'entreposage de la zone de fabrication suivante, si aucune place d'entreposage n'a été trouvée dans la zone de fabrication initialement prévue.
